Europäisches Patentamt

European Patent Office

Office européen des brevets

(19)

(11) Publication number: **0 257 528 B1**

# EUROPEAN PATENT SPECIFICATION

(12)

(45) Date of publication of patent specification:
30.01.91 Bulletin 91/05

(51) Int. Cl.⁵: **H01J 9/12, H01J 1/34,**
**H01J 37/30, H01L 21/31**

(21) Application number: 87111980.6

(22) Date of filing: 18.08.87

(54) Photo cathodes for electron image projection.

(30) Priority: 18.08.86 JP 192448/86

(43) Date of publication of application:
02.03.88 Bulletin 88/09

(45) Publication of the grant of the patent:
30.01.91 Bulletin 91/05

(84) Designated Contracting States:
DE FR GB

(56) References cited:
EP-A- 0 182 665
FR-A- 2 233 709
GB-A- 1 538 738
GB-A- 1 589 925
GB-A- 2 157 884
US-A- 4 005 465

(73) Proprietor: FUJITSU LIMITED
1015, Kamikodanaka Nakahara-ku
Kawasaki-shi Kanagawa 211 (JP)

(72) Inventor: Sakamoto, Kiichi Fujitsu Ltd Pat.
Dep.
Kosugi Fujitsu Blg 1812-10 Shimonumabe
Nakahara-ku Kawasaki-shi Kanagawa 211
(JP)
Inventor: Yasuda, Hiroshi Fujitsu Ltd Pat. Dep.
Kosugi Fujitsu Blg 1812-10 Shimonumabe
Nakahara-ku Kawasaki-shi Kanagawa 211
(JP)
Inventor: Kudou, Jinko Fujitsu Ltd Pat. Dep.
Kosugi Fujitsu Blg 1812-10 Shimonumabe
Nakahara-ku Kawasaki-shi Kanagawa 211
(JP)
Inventor: Yamada, Akio Fujitsu Ltd Pat. Dep.
Kosugi Fujitsu Blg 1812-10 Shimonumabe
Nakahara-ku Kawasaki-shi Kanagawa 211
(JP)

(74) Representative: Sunderland, James Harry et
al
HASELTINE LAKE & CO Hazlitt House 28
Southampton Buildings Chancery Lane
London WC2A 1AT (GB)

## Description

The present invention relates to photo cathodes used in electron image projection apparatus.

Photo lithography techniques are important in the production of integrated circuits (ICs). Among such techniques, an electron image projection technique has been proposed, by T. W. O'Keefe et al in "An Electron Imaging System for the Fabrication of Integrated Circuits", Solid State Electronics, Vol. 12, page 841, 1969, as a technique which might satisfy the demand for sub-micron resolution. This technique has been intensively studied and developed by many people, for example as reported by I. Mori et al in "An Electron Beam-Image-Projection System for Submicron", Toshiba Review, Vol. 41, No. 5, 1986.

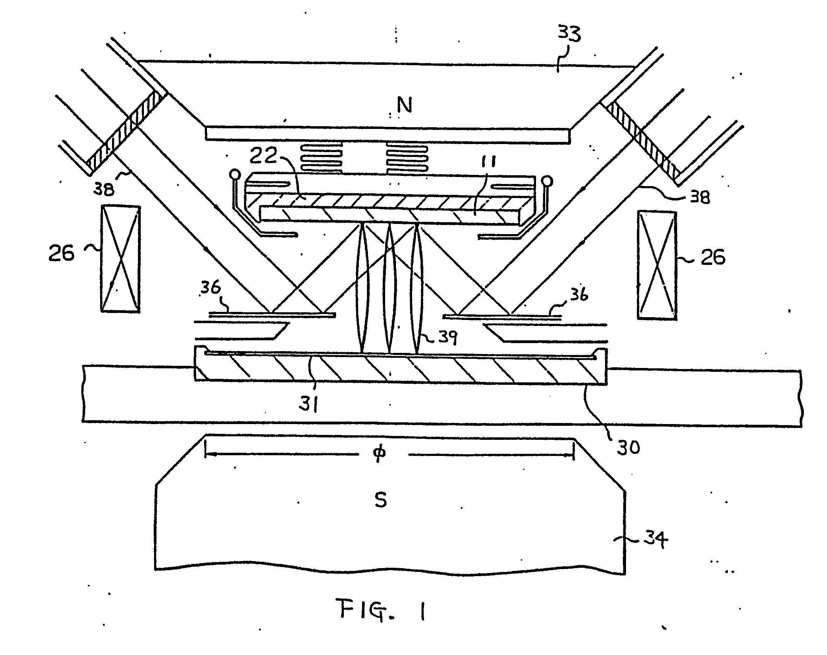

The main structure of an electron image projection apparatus in vacuum ($1,33.10^{-7}$ to $1,33.10^{-4}$Pa ; $10^{-9}$ to $10^{-6}$ Torr) is schematically illustrated in Fig. 1.

A mask substrate 11, which has been patterned in advance with a photo cathode material as will be described below, is held in a mask holder 22. A semiconductor wafer 31 on which the pattern on the mask substrate 11 is to be copied is placed facing and parallel to the mask substrate 11, approximately 30 mm distant, on a wafer holder 30. Ultra violet light 38 of a proper wavelength is irradiated on to the front surface of the mask substrate 11, reflected by reflectors 36 (or is irradiated onto the back surface of the mask substrate when that substrate is of transparent material and when an apparatus is used which is not as shown in the Figure). The patterned photo cathode is photo electrically excited and emits photo electrons, which are accelerated by an applied voltage of approximately 80 kV between the mask substrate 11 and the wafer 31. This voltage is applied by supplying −80 kV to the mask substrate 11 and 0 V to the wafer 31. On the other hand, a magnetic field is applied perpendicular to the surface of the mask substrate 11 as well as the wafer 31. Emitted and accelerated electrons 39 are thus accurately focused on the surface of the wafer 31 by the applied electric and magnetic fields. The magnetic field is applied from magnetic poles 33, 34 and a compensation coil 26, for providing a uniform magnetic field. An E-beam (electron beam) resist material, such as PMMA (polymethyl methacrylate), coated on the semiconductor wafer 31 is thus exposed, by the accelerated and focused electrons, with the pattern of the photo cathode material on the mask substrate 11. This is the principle of electron image projection.

There are two main types of photo cathode used for such electron image projection, employing different materials. The first is a type using CsI (caesium iodide) and the second is a type using semiconductor material, such as GaAs (gallium arsenide), having caesium, etc., thereon, as disclosed by Yasuda et al in United States Patent application No. 799 321.

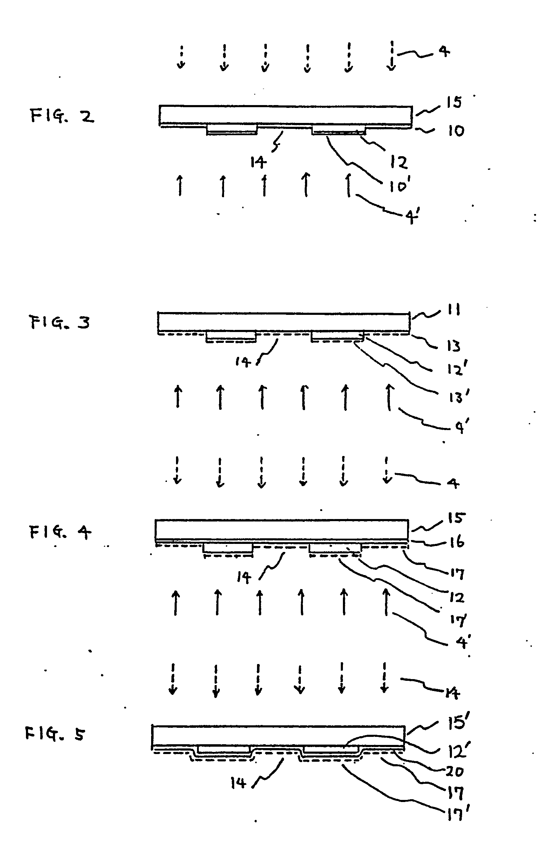

The structure of a photo cathode of the first type, for use with back or front illuminating light, is schematically illustrated in Fig. 2. Upon a substrate 15 which is made of quartz or sapphire, and is therefore transparent to the illuminating ultra violet light, a Cr (chrome) layer is patterned as indicated at 12 by a conventional photo mask making technique, such as sputtering, electron beam exposure and etching. Then, CsI is deposited over the surface of the patterned substrate 15, as indicated at 10 and 10'. Ultra violet light 4 is irradiated onto the back surface of the substrate 15 (light 4' may alternatively be illuminated on to the front surface), through which the light photo electrically excites the CsI 10 coated directly on the substrate, indicated as photo cathode 14 in Fig. 2. The light-excited CsI 10 emits photo electrons, which are pulled out of the surface by the applied electric field. The Cr pattern 12 prevents light from reaching CsI layer parts 10' formed on that pattern. Thus, the photo cathode 14 is patterned.

The structure of a photo cathode of the second type, for use with front illuminating light, is schematically illustrated in Fig. 3. Upon a substrate 11 made of a photoelectric material, such as GaAs, which is not transparent for the irradiating light, a tungsten layer for masking non-cathode portions is patterned as indicated at 12' by a conventional lithography technique, such as sputtering, electron beam exposure and etching. Then, several atomic layers of Cs 13 and 13' are coated over the surface of the tungsten-patterned GaAs substrate 11. Ultra violet light 4' is irradiated on to the surface of the patterned substrate 11 having the Cs layering 13 directly thereon. Photo cathode portion 14, where the GaAs substrate absorbs the light 4' through the Cs layer 13 and produces photo electrons therein, emits electrons, which are pulled out of the surface by the applied electric field. The tungsten pattern 12' having Cs atoms 13' thereon emits a much lesser quantity of photo electrons than the GaAs with Cs thereon. Thus, a patterned photo cathode is formed.

Problems of the first (CsI) type of cathode are as follows :

1. The work function for the emission of a photo electron is as high as approximately 6 eV, which means that a low-pressure mercury lamp, emitting light of wavelength 184,9 nm (1849 Angstroms), or so, is required as a light source for irradiation of the photo cathode. However, no suitable focusing means are available for light of this wavelength.

2. The lifetime of the CsI is not long enough for an efficient IC fabrication process. This is because the CsI is not only very deliquescent but also reduces itself even in a vacuum. This also means it is impossible to take a CsI coated mask into air, for example for inspection of the uniformity of the CsI coating.

Problems of the second (GaAs plus Cs) type of cathode are as follows :

After a masking pattern is formed of tungsten etc. by a method such as sputtering, lithography and etching, on the surface of the GaAs substrate, the surface of the GaAs substrate must be cleaned up by being heated at 630°C or higher in a high vacuum, so that contaminating material on the substrate is evaporated. Accordingly, the atoms of the substrate material can contact Cs atoms for reducing the work function of the surface of the photo cathode. However, this heat cleaning does not always reliably provide a satisfactorily clean surface and less uniform, i.e. less stable, photo electron emissivity may result. Further, the heating process makes masking metal diffuse laterally into the cathode portion 14 which is not masked by the masking metal. The borderlines between masked and non-masked areas (i.e. 14) are made less sharp, namely blurred, by this diffusion. At blurred edges photo electron emissivity deteriorates, resulting in deterioration of sharpness, i.e. resolution, of image projection.

For example, EP-A-0 182 665 discloses the use of $Ag_2O$ in a photo cathode. US-A-4 005 465 discloses a photocathode with an emitter layer as silver evaporated onto an insulating layer provided on a semiconductor layer and subsequently treated with caesium and oxygen.

According to the present invention there is provided a photo cathode, employing silver as photoelectric material, with a layer of alkali or alkali earth metal on the silver, effective to lower the work function of the silver.

An embodiment of the present invention can provide a photo cathode structure which is more stable, i.e. less susceptible to damage by the atmosphere and easier to handle for efficient electron image projection operations, and of improved uniformity.

An embodiment of the present invention can provide a photo cathode structure with which sub-micron resolution can be achieved, as required in VLSI (Very Large Scale Integration) fabrication.

In an example of an embodiment of the present invention, a photo cathode patterned on a mask substrate is made of an Ag (silver) layer and several atomic layers of alkali metal or alkali earth metal coated on the silver layer.

The silver layer may be coated over all of a surface of the substrate, then non-cathode portions masked with a pattern of a non-photoelectric material, such as tungsten.

Alternatively, the silver layer may itself be patterned to the required cathode pattern

Alternatively again, the substrate may itself be of silver, in effect providing the silver layer mentioned above as an integral part of the substrate.

With a photo cathode in accordance with an embodiment of the present invention, a mercury lamp providing light of wavelength 365 nm (3650 Angstroms) can be used.

Reference is made, by way of example, to the accompanying schematic drawings, in which :

Fig. 1 illustrates general structure of a front or surface illumination electron beam projection apparatus ;

Fig. 2 is a cross-sectional illustration of a previously proposed photo cathode structure, using CsI as photo cathode material, for back or front illumination ;

Fig. 3 is a cross-sectional illustration of a previously proposed photo cathode structure, using GaAs as photo cathode material, for front or surface illumination ;

Figs 4 to 7 are cross sectional illustrations of photo cathode structures in accordance with exemplary embodiments of the present invention; and

Fig. 8 is a graph illustrating photo cathode lifetimes.

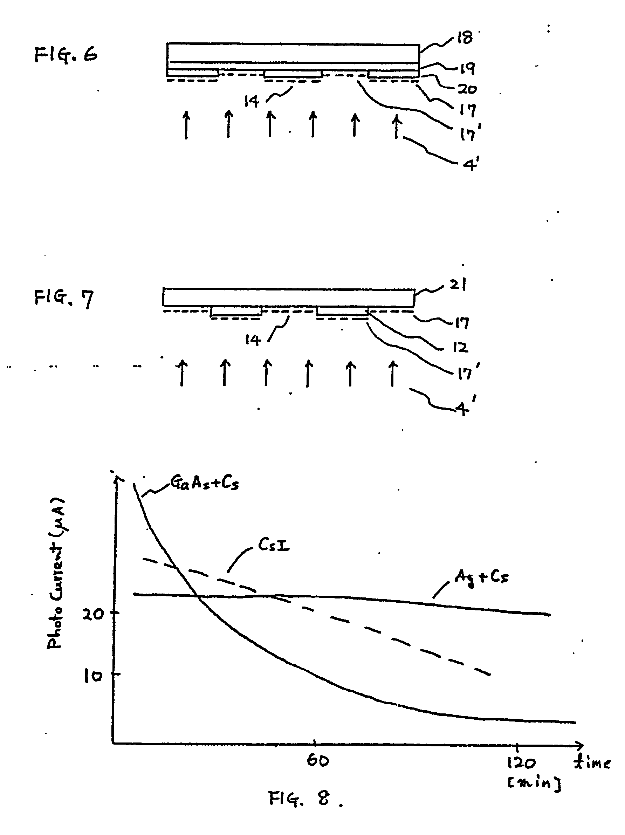

A photo cathode structure for front (surface) or back illumination, in accordance with an embodiment of the present invention, is shown in Fig. 4. Upon the surface of a substrate 15 of transparent material, such as quartz or sapphire, an Ag (silver) layer 16 is coated to a thickness for example in the range 10 Angstroms to 1μm, for instance 15 nm (150 Angstroms), by a method such as sputtering, vapour deposition or plating. If the Ag layer is thinner than 1 nm (10 Angstroms), photo electron emissivity is not secured. A layer 12 of non-photoelectric material, or of non-transparent material, such as Cr, Pt (platinum), Au (gold), W (tungsten), Mo (molybdenum), Ti (titanium), Ta (tantalum) etc., is patterned on the Ag layer 16. The layer 12 has a thickness for example in the range 10–400nm (100 to 4000 Angstroms), for instance 100 nm (1000 Angstroms), and may be patterned by any suitable lithography technique, such as E-beam lithography. The patterned layer 12 masks locally non-cathode portions. A layer 17, 17' of an alkali metal, such as Cs, K (potassium), or Rb (rubidium), or an alkali earth metal such as Ba (barium) or Ca (calcium), is coated over the surface of the patterned substrate, to a thickness of as much as several atomic layers.

Layers designated 17, 17' will be referred to as Cs (caesium) layers below, by way of example and for brevity, but it is to be understood that such layers may be of any alkali or alkali earth metal.

The Cs layer 17, 17' may be coated, for example, by a caesium ion beam technique, by evaporation of caesium chromate, or by use of a commercially available so-called caesium dispenser. Heating the substrate in caesium vapour is also effective.

After coating with the Cs layer 17, 17', the substrate 15 is heated in vacuo at 50 to 200°C for, generally, 1 to 10 minutes. If heating time is too long, there is a deterioration in exposure contrast, and if it is too short its effect is unreliable, in other words electron emissivity may be low. The processed substrate 15 with the Cs layer thereon is loaded in electron image projection apparatus, for example as shown in Fig. 1, generally without being exposed to air, for better electron emissivity. If the apparatus is for back irradiation through the transparent substrate 15 on to the back of the Ag layer 16, the magnet pole 33, 34 are removed and replaced by magnet coils (not shown in Fig. 1) in order to clear a path for light. The light, 4 or 4′, irradiated onto the Ag layer 16 from either front or back (through the transparent substrate), excites the Ag layer and produces photo electrons therein. The photo electrons are pulled out by the applied electric field to the surface of the Ag layer, where the Cs coating helps the electrons emerge from the cathode because it reduces the work function of the cathode.

If the Ag layer is irradiated from the back, if the Ag layer is too thick the produced photo electrons cannot reach the opposite surface from which they are to emerge. The portions of the Ag layer covered by the masking metal pattern 12 also produce photo electrons, but these do not emerge (into the vacuum of the apparatus), because the masking metal 12 (with Cs thereon) is not active to emit electrons. The produced photo electrons loose scattering energy and finally vanish. If the masking pattern 12 is too thin, irradiating light passes therethrough, causing deterioration in exposure contrast. Too thick a masking pattern may cause no particular problem. Thus, an exposure contrast, i.e. ratio of electron current from photo cathode portions to electron current from masked portions, of as high as approximately 20 can be attained.

For cases in which the photo cathode is irradiated from the front (surface or outer side irradiation), the substrate may be of non-transparent material, and too great a thickness of the Ag layer may cause problems. The masking metal pattern 12 shields the Ag layer surface from front irradiating light 4′, and thus portions of the Ag layer under the masking pattern do not produce photo electrons, unless the masking pattern is too thin. If light passes through the masking pattern, the projected image becomes less sharp. If the masking pattern is too thick, shadowing of to the masking pattern on to the photo cathode (non-masked) portions can result in deterioration of sharpness of the projected image.

Fig. 5 illustrates the structure of a photo cathode for back irradiation, in accordance with another embodiment of the present invention. This structure has a suitable transparent substrate material, e.g. quartz or sapphire, as in the embodiment of Fig. 4.

Over a substrate 15′, a layer 12′ of non-photoelectric or non-transparent material, such as W, Mo, Cr, Pt, Au, Ti, Ta, or the like, is coated and patterned, similarly to the layer 12 in the embodiment of Fig. 4. A silver (Ag) layer 20 is formed over the exposed surfaces of the substrate 15′ and patterned layer parts 12′ as in the embodiment of Fig. 4. Over the silver layer 20, a layer 17, 17′ of an alkali metal, such as Cs, K (potassium), or Rb (rubidium), or an alkali earth metal such as Ba (barium) or Ca (calcium), is coated over the surface of the patterned substrate, to a thickness of as much as several atomic layers.

Layers designated 17, 17′ are, as mentioned above, referred to as Cs (caesium) layers in this embodiment and embodiments described below, by way of example and for brevity, but it is to be understood that such layers may be of any alkali or alkali earth metal.

The photo cathode of Fig. 5 is similar to that of Fig. 4, with the order in which the silver layers (16 in Fig. 4 and 20 in Fig. 5) and e.g. tungsten patterns (12 in Fig. 4 and 12′ in Fig. 5) are applied to the substrate reversed between Fig. 4 and Fig. 5.

Fig. 6 illustrates the structure of a photo cathode for front (surface) irradiation, in accordance with another embodiment of the present invention.

Over a substrate 18, which is not required to be transparent for the irradiating light and therefore can be of a material readily available in the industry, such as silicon, a layer 19 of non-photoelectric material, such as W, Mo, Cr, Pt, Au, Ti, Ta, or the like, is coated to a thickness in the range, for example, of 10-400 nm (100 to 4000 Angstroms), for instance 200 nm (2000 Angstroms), by a method such as sputtering. This layer acts as a conductor to supply electrons to the photo cathode. Upon the layer 19, an Ag layer 20 is patterned. The layer 19 has a thickness, for example, in the range 500 Angstroms to 1μm, for instance 100 nm (1000 Angstroms). The patterning can be accomplished by a method using a lithography technique or a lift-off method. The patterned Ag layer 20 thus forms the pattern of the photocathode. The thickness of the Ag layer is not critical for the quality of the produced image. Next, Cs 17, 17′ is deposited on all of the exposed surface of the layers 19 and 20, to a thickness of as much as several atomic layers, in the same way as described for Fig. 4. The resulting photo cathode is indicated at 14.

The processed substrate with the Cs layering is loaded in to electron image projection apparatus, for example as shown in Fig. 1, usually without being exposed to air. When light 4′ (38 in Fig. 1) is irradiated on to the surface (front) of the processed substrate, with application of electric and magnetic fields, the patterned Ag layer 20 with Cs layer 17 thereon acts as photo cathode 14 to emit electrons. Other portions, where Cs layer 17′ lays directly on metal layer 19, emit considerably fewer electrons than the Ag portions with Cs thereon, a relatively negligible quantity of electrons.

Fig. 7 illustrates the structure of another photo cathode for front (surface) irradiation, in accordance with an embodiment of the present invention.

In this case, a substrate 21 made of Ag is employed in place of a substrate with an Ag layer thereon (see e.g. Fig. 4). Other features of the structure of Fig. 7 are similar to those of Fig. 4. The structure of Fig. 7 can be used only with front (surface or outer) irradiation.

Embodiments of the present invention offer the following advantages :

1. The absorption edge of Ag is approximately 4 eV, which is lower than that (6 eV) of CsI. This means that the light for exciting photo electrons can have a wavelength of, for example 300-400 nm (3000 to 4000 Angstroms), for instance the so-called "i-line", i.e. 365 nm (3650 Angstroms). This wavelength can be produced by a super high pressure mercury lamp, which can deliver a strong i-line, easy for focusing. On the other hand, a low pressure mercury lamp which delivers light of a relatively shorter wavelength, not easy for focusing, must be used for a CsI type photo cathode. Light of 300–400 nm (3000 to 4000 Angstroms) can easily be focused by a lens, so that high density light can be irradiated on to a photo cathode, to provide output of a higher electron current.

2. After alkali/alkali earth metal (e.g. Cs) is coated over the Ag layer, heating to 50 to 200° C, as mentioned above, is preferable. This heating process can provide a significant improvement in photo cathode emissivity : e.g. photo electron current of $0.1\mu A$ was increased to $20\mu A$ after heat processing, a two hundred times improvement, with other conditions, such as acceleration voltage, magnetic field or light intensity kept the same as those of previously proposed apparatus. It is believed that the heating process makes a purer and more stable contact between Ag and the coating material. The heating process temperature is much lower than the 630 to 680°C required by the previously proposed GaAs substrate with Cs thereon for reducing work function. Thus, the problem of the previously proposed GaAs substrate - diffusion caused by high temperature processing causing less sharp edges of masked non-cathode portions - does not arise. Resolution of 0.4 to 0.5 µm can be reliably achieved, and resolution of 0.15 to 0.3 µm can be achieved quite readily.

3. A photo cathode in accordance with an embodiment of the present invention can have a life longer than that of a previously proposed photo cathode having a GaAs substrate with Cs thereon. This is indicated in the graph of Fig. 8 where photo current is plotted against time. In the graph the curve Ag+Cs relates to an embodiment of the present invention, whilst curve GaAS+Cs relates to the previously proposed cathode mentioned above. The curve CsI relates to the previously proposed photo cathode type using a CsI layer. This latter curve is merely schematic and illustrative, plotted to a free scale, indicating in a general sense the performance of this type of photo cathode relative to the other types. As illustrated, when the photo cathodes are used in evacuated electron image projection apparatus, photo cathode operation decays. For the embodiment of the present invention, decay is very slow, over several tens of hours. The GaAs+Cs type of photocathode decays quickly : for the first several minutes it emits ten times more electrons than subsequently and continues to decay. The CsI type is deliquescent, and electron emission decays to half level after the first several hours. The embodiment of the present invention can thus offer improvement in the throughput of electron beam processing.

4. Fluctuation of photo electron emissivity between mask substrates (between photo cathodes) is reduced from the 30% of the GaAs+Cs type to 10% for an embodiment of the present invention. This is believed to be achieved by the pure contact of the Cs atoms to their Ag base as well as the reason mentioned in 3. above, and contributes to uniform and high quality fabrication of ICs.

5. Used mask substrates can be reused by redeposition of alkali/alkali earth metal thereon in vacuo. For reclamation of the GaAs substrate of the GaAs+Cs type, about 150 minutes are required, because the substrate and the tools must be heated to as much as 630 C and must be cooled in vacuo. However, the mask substrate of an embodiment of the present invention can be cooled in only three minutes, because the heating temperature is much lower. This contribute to improvement of throughput of electron beam processing.

6. It is possible to take a substrate in accordance with the present invention, with alkali/alkali earth metal applied to the Ag, out of vacuum, because the Ag is not susceptible to damage by air. This enables a visual check of the processed surface of the photo cathode for uniformity etc., and contributes to uniform and high quality fabrication of ICs. Such visual checking of CsI type cathodes is absolutely impossible because of the deliquescence of the CsI.

7. Photo cathodes in accordance with embodiments of the present invention enable both negative and positive electron beam exposures of resists, such as PMMA, which can withstand a dry etching atmosphere.

In a photocathode in accordance with an embodiment of the present invention, for electron image projection apparatus, uses silver as a photo electric material, for example in a layer on a substrate, with a layer of alkali or alkali earth metal, such as caesium, on the silver. The caesium layer is as thick as several atomic layers and serves to reduce the work function of the photo cathode.

On a silver substrate, or a silver layer coated over the whole of a non-silver substrate, non-cathode portions may be masked by a non-photoelectric metal or a non-transparent metal, such as platinum.

Alternatively, a silver layer may be patterned on a layer of non-photoelectric metal coated on a substrate.

Light for exciting a photocathode may be irradiated on to the front of the photocathode or onto the back, to reach a silver layer through a transparent substrate, when the photo cathode structure is suitable.

After deposition of the alkali/alkali earth metal, e.g. caesium, on the silver, heating at 50 to 200°C in vacuum is carried out. A contrast ratio, ratio of electron currents from cathode and non-cathode portions, as high as 20 can be achieved. The low heating temperature prevents lateral diffusion of masking metal, giving sharp edges to the cathode pattern.

The silver with alkali/alkali earth metal, e.g. caesium, thereon is not susceptible to damage by air, so long life and easy handling can be provided for efficient photolithography processing.

The low absorption edge of the silver allows the use of a high pressure mercury lamp whose light can easily be focused by a lens.

## Claims

1. A photo cathode, with essentially pure silver as photoelectric material, with a layer of alkali or alkali earth metal on the silver, effective to lower the work function of the silver.

2. A photo cathode as claimed in claim 1, wherein the layer of alkali or alkali earth metal is of caesium, potassium, rubidium, barium or calcium.

3. A photo cathode as claimed in claim 1 or 2, wherein the layer of alkali or alkali earth metal is several atomic layers thick.

4. A photo cathode a claimed in any preceding claim, for use in electron image projection apparatus, patterned in accordance with a desired electron image, having a silver substrate, a patterned non-photoelectric metal masking layer on the substrate, locally masking parts of the substrate, with the layer of alkali or alkali earth metal formed over the masking layer and exposed substrate surface parts.

5. A photo cathode a claimed in any of claims 1 to 3, for use in electron image projection apparatus, patterned in accordance with a desired electron image, having a substrate, a silver layer on the substrate, a patterned non-photoelectric metal masking layer on the silver layer, locally masking parts of the silver layer, with the layer of alkali or alkali earth metal formed over the masking layer and exposed silver layer surface parts.

6. A photo cathode a claimed in any of claims 1 to 3, for use in electron image projection apparatus, patterned in accordance with a desired electron image, having a substrate, a non-photoelectric and conductive masking layer on the substrate, a patterned silver layer on the masking layer, with the layer of alkali or alkali earth metal formed over the silver layer and exposed masking layer surface parts.

7. A photo cathode a claimed in any of claims 1 to 3, for use in electron image projection apparatus, patterned in accordance with a desired electron image, having a transparent substrate, transparent to light of a wavelength for which the silver is photoelectrically active, for example of quartz or sapphire, a patterned non-transparent masking layer on the substrate, a silver layer on the masking layer, with the layer of alkali or alkali earth metal formed over the silver layer and exposed masking layer surface parts.

8. A photo cathode as claimed in claim 5 or 6, wherein the substrate is transparent to light of a wavelength for which the silver is photoelectrically active, for example of quartz or sapphire.

9. A photocathode as claimed in claim 5 or 6, wherein the substrate is non-transparent to light of a wavelength for which the silver is photoelectrically active, for example of silicon.

10. A photo cathode as claimed in claim 7, wherein the silver layer is $10^{-9}$ m to $5 \cdot 10^{-7}$ m thick.

11. A photo cathode as claimed in claim 5, wherein the silver layer is $10^{-3}$ μm to 1 μm thick.

12. A photo cathode as claimed in claim 6, wherein the silver layer is 0,05 μm to 1 μm thick.

13. A photo cathode as claimed in claim 4, 5, 6, 7, 8, 9, 10, 11 or 12, wherein the masking layer is of tungsten, chrome, gold, platinum, molybdenum, tantalum or titanium.

14. A photo cathode as claimed in claim 10, wherein the masking layer is $10^{-8}$ m to $4 \cdot 10^{-7}$ m thick.

15. A photo cathode as claimed in claim 13, read as appended directly or indirectly to claim 7, wherein the masking layer is thicker than $5 \cdot 10^{-8}$ m

16. Electron image projection apparatus, comprising a photo cathode as claimed in any of claims 4 to 15 and a high-pressure mercury lamp for providing light for irradiating the photo cathode.

17. Electron image projection apparatus, comprising a photo cathode as claimed in any of claims 4 to 15 and a light-source for irradiating the photo cathode with light of a wavelength shorter than $4 \cdot 10^{-7}$ m.

18. Electron image projection apparatus, comprising a photo cathode as claimed in any of claims 4 to 15 and a light-source for irradiating the photo cathode with light of a wavelength between $3 \cdot 10^{-7}$ and $4 \cdot 10^{-7}$ m.

19. Electron image projection apparatus, comprising a photo cathode as claimed in any of claims 4 to 15 and a light-source for irradiating the photo cathode with light of a wavelength of substantially 3,65·10⁻⁷ m.

20. A method of manufacturing a photo cathode as claimed in any one of claims 1 to 15, comprising treating the silver with the layer of alkali or alkali earth metal thereon in vacuo by heating to a temperature in the range 50 to 200°C.

## Ansprüche

1. Photokathode mit im wesentlichen reinem Silber als photoelektrischem Material, mit einer Schicht aus Alkali oder Alkalierdmetall auf dem Silber, effektiv zur Herabsetzung der Austrittsarbeit des Silbers.

2. Photokathode nach Anspruch 1, bei der die Schicht aus Alkali oder Alkalierdmetall aus Cäsium, Kalium, Rubidium, Barium oder Kalzium besteht.

3. Photokathode nach Anspruch 1 oder 2, bei der die Schicht aus Alkali oder Alkalierdmetall merere Atomschichten dick ist.

4. Photokathode nach einem der vorhergehenden Ansprüche, zur Verwendung in einer elektronischen Bildprojektionsvorrichtung, gemustert in Übereinstimmung mit einem gewünschten Elektronenbild, mit einem Silbersubstrat, einer gemusterten, nicht photoelektrischen Metallmaskenschicht auf dem Substrat, lokal maskierenden Teilen des Substrats, wobei die Schicht aus Alkali oder Alkalierdmetall über der Maskenschicht und den exponierten Substratoberflächenteilen gebildet ist.

5. Photokathode nach einem der Ansprüche 1 bis 3, zur Verwendung in einer elektronischen Bildprojektionsvorrichtung, gemustert in Übereinstimmung mit einem gewünschten Elektronenbild, mit einem Substrat, einer Silberschicht auf dem Substrat, einer gemusterten, nicht-photoelektrischen Metallmaskenschicht auf der Silberschicht, lokal maskierenden Teilen der Silberschicht, wobei die Schicht aus Alkali oder Erdalkalimetall über der Maskenschicht und den exponierten Silberschichtoberflächenteilen gebildet ist.

6. Photokathode nach einem der Ansprüche 1 bis 3, zur Verwendung in einer elektronischen Bildprojektionsvorrichtung, gemustert in Übereinstimmung mit einem gewünschten Elektronenbild, mit einem Substrat, einer nicht-photoelektrischen und leitenden Maskenschicht auf dem Substrat, einer gemusterten Silberschicht auf der Maskenschicht, wobei die Schicht aus Alkali oder Alkalierdmetall über der Silberschicht und den exponierten Teilen der Maskenschichtoberfläche gebildet ist.

7. Photokathode nach einem der Ansprüche 1 bis 3, zur Verwendung in einer Elektronenbildprojektionsvorrichtung, gemustert in Übereinstimmung mit einem gewünschten Elektronenbild, mit einem transparenten Substrat, das gegenüber Licht von einer Wellenlänge transparent ist, für welche das Silber photoelektrisch aktiv ist, zum Beispiel aus Quartz oder Saphir, einer gemusterten nicht-transparenten Maskenschicht auf dem Substrat, einer Silberschicht auf der Maskenschicht, wobei die Schicht aus Alkali oder Alkalierdmetall über der Silberschicht und exponierten Teilen der Maskenschichtoberfläche gebildet ist.

8. Photokathode nach Anspruch 5 oder 6, bei der das Substrat gegenüber Licht von einer Wellenlänge transparent ist, für welche Silber photoelektrisch aktiv ist, zum Beispiel aus Quartz oder Saphir.

9. Photokathode nach Anspruch 5 oder 6, bei der das Substrat gegenüber Licht von einer Wellenlänge, für welche Silber photoelektrisch aktiv ist, nicht transparent ist, zum Beispiel aus Silizium.

10. Photokathode nach Anspruch 7, bei der die Silberschicht 10⁻⁹ m bis 5×10⁻⁷ m dick ist.

11. Photokathode nach Anspruch 5, bei der die Silberschicht 10⁻³ µm bis 1 µm dick ist.

12. Photokathode nach Anspruch 6, bei der die Silberschicht 0,05 µm bis 1 µm dick ist.

13. Photokathode nach Anspruch 4, 5, 6, 7, 8, 9, 10, 11 oder 12, bei der die Maskenschicht aus Wolfram, Chrom, Gold, Platin, Molybdän, Tantal oder Titan ist.

14. Photokathode nach Anspruch 10, bei der die Maskenschicht 10⁻⁸ m bis 4×10⁻⁷ m dick ist.

15. Photokathode nach Anspruch 13, direkt oder indirekt in Verbindung mit Anspruch 7 gelesen, bei der die Maskenschicht dicker als 5-10⁻⁸ m ist.

16. Elektronische Bildprojektionsvorrichtung mit einer Photokathode nach einem der Ansprüche 4 bis 15 und einer Hochdruckquecksilberlampe zum Liefern von Licht zur Bestrahlung der Photokathode.

17. Elektronische Bildprojektionsvorrichtung mit einer Photokathode nach einem der Ansprüche 4 bis 15 und einer Lichtquelle zur Bestrahlung Photokathode mit einem Licht von einer Wellenlänge kürzer als 4×10⁻⁷ m.

18. Elektronische Bildprojektionsvorrichtung mit einer Photokathode nach einem der Ansprüche 4 bis 15 und einer Lichtquelle zur Bestrahlung Photokathode mit einem Licht von einer Wellenlänge zwischen 3×10⁻⁷ m und 4×10⁻⁷ m.

19. Elektronische Bildprojektionsvorrichtung mit einer Photokathode nach einem der Ansprüche 4 bis 15 und einer Lichtquelle zur Bestrahlung Photokathode mit einem Licht von einer Wellenlänge von im wesentlichen 3,65×10⁻⁷ m.

20. Verfahren zur Herstellung einer Photokathode nach einem der Ansprüche 1 bis 15, einschließlich der Behandlung des Silbers mit der Schicht aus Alkali oder Erdalkalimetall darauf in einem Vakuum durch Erhitzen auf eine Temperatur in dem Bereich von 50 bis 200°C.

## Revendications

1. Photocathode comportant de l'argent pratiquement pur comme matière photoélectrique, munie d'une couche d'un métal alcalin ou alcalino-terreux placée sur l'argent et réduisant efficacement le travail d'extraction de l'argent.

2. Photocathode selon la revendication 1, dans laquelle la couche de métal alcalin ou alcalino-terreux est formée de césium, de potassium, de rubidium, de baryum ou de calcium.

3. Photocathode selon la revendication 1 ou 2, dans laquelle la couche de métal alcalin ou alcalino-terreux a une épaisseur de plusieurs couches atomiques.

4. Photocathode selon l'une quelconque des revendications précédentes, destinée à être utilisée dans un appareil de projection d'image électronique et formant un dessin correspondant à une image électronique voulue, la photocathode ayant un substrat d'argent, et une couche formant un dessin de masque d'un métal non photoélectrique, placée sur le substrat et masquant localement des parties du substrat, la couche du métal alcalin ou alcalino-terreux étant formée sur la couche de masque et sur les parties exposées de la surface du substrat.

5. Photocathode selon l'une quelconque des revendications 1 à 3, destinée à être utilisée dans un appareil de projection d'image électronique formant un dessin correspondant à une image électronique voulue, ayant un substrat, une couche d'argent placée sur le substrat et une couche d'un masque d'un métal non photoélectrique formant un dessin sur la couche d'argent et masquant localement des parties de la couche d'argent, la couche du métal alcalin ou alcalino-terreux étant formée sur la couche de masque et sur les parties exposées de la surface de la couche d'argent.

6. Photocathode selon l'une quelconque des revendications 1 à 3, destinée à être utilisée dans un appareil de projection d'image électronique, formant un dessin correspondant à une image électronique voulue, ayant un substrat, une couche conductrice et non photoélectrique de masque formée sur le substrat, et une couche d'argent formée suivant un dessin sur la couche de masque, la couche de métal alcalin ou alcalino-terreux étant placée sur la couche d'argent et sur les parties exposées de la surface de la couche de masque.

7. Photocathode selon l'une quelconque des revendications 1 à 3, destinée à être utilisée dans un appareil de projection d'image électronique et formant un dessin correspondant à une image électronique voulue, ayant un substrat transparent à la lumière à une longueur d'onde à laquelle l'argent est photoélectriquement actif, le substrat étant par exemple formé de quartz ou de saphir, une couche non transparente de masque formant un dessin sur le substrat, et une couche d'argent placée sur la couche de masque, la couche du métal alcalin ou alcalino-terreux étant formée sur la couche d'argent et sur des parties exposées de la surface de la couche de masque.

8. Photocathode selon la revendication 5 ou 6, dans laquelle le substrat est transparent à la lumière à une longueur d'onde à laquelle l'argent est photoélectriquement actif, et est par exemple formé de quartz ou de saphir.

9. Photocathode selon la revendication 5 ou 6, dans laquelle le substrat n'est pas transparent à la lumière à une longueur d'onde à laquelle l'argent est photoélectriquement actif, et est par exemple formé de silicium.

10. Photocathode selon la revendication 7, dans laquelle la couche d'argent a une épaisseur comprise entre $10^{-9}$ et $10^{-7}$ m.

11. Photocathode selon la revendication 5, dans laquelle la couche d'argent a une épaisseur comprise entre $10^{-3}$ et 1 µm.

12. Photocathode selon la revendication 6, dans laquelle la couche d'argent a une épaisseur comprise entre 0,05 et 1 µm.

13. Photocathode selon la revendication 4, 5, 6, 7, 8, 9, 10, 11 ou 12, dans laquelle la couche de masque est formée de tungstène, de chrome, d'or, de platine, de molybdène, de tantale ou de titane.

14. Photocathode selon la revendication 10, dans laquelle la couche de masque a une épaisseur comprise entre $10^{-8}$ et $4 \cdot 10^{-7}$ m.

15. Photocathode selon la revendication 13, dépendant directement ou indirectement de la revendication 7, dans laquelle la couche de masque a une épaisseur supérieure à $5 \cdot 10^{-8}$ m.

16. Appareil de projection d'image électronique, comprenant une photocathode selon l'une quelconque des revendications 4 à 15 et une lampe à vapeurs de mercure à haute pression destinée à donner de la lumière d'irradiation de la photocathode.

17. Appareil de projection d'image électronique, comprenant une photocathode selon l'une quelconque des revendications 4 à 15 et une source lumineuse destinée à irradier la photocathode avec de la lumière à une longueur d'onde inférieure à $4 \cdot 10^{-7}$ m.

18. Appareil de projection d'image électronique, comprenant une photocathode selon l'une quelconque des revendications 4 à 15, et une source lumineuse destinée à irradier la photocathode avec de la lumière ayant une longueur d'onde comprise entre $3 \cdot 10^{-7}$ et $4 \cdot 10^{-7}$ m.

19. Appareil de projection d'image électronique, comprenant une photocathode selon l'une quelconque des revendications 4 à 15 et une source lumineuse destinée à irradier la photocathode avec de la lumière à une longueur d'onde sensiblement égale à $3,65 \cdot 10^{-7}$ m.

20. Procédé de fabrication d'une photocathode selon l'une quelconque des revendications 1 à 15, comprenant le traitement sous vide de l'argent portant la couche du métal alcalin ou alcalino-terreux par chauffage à une température comprise entre 50 et 200°C.

FIG. I

FIG. 2

FIG. 3

FIG. 4

FIG. 5

FIG. 6

18
19
20
17
17'
4'

14

FIG. 7

21
17
12
17'
4'

14

Photo Current (µA)

GaAs+Cs

CsI

Ag+Cs

20

10

60                    120    time
                              [min]

FIG. 8.